# EUROPEAN PATENT SPECIFICATION

(11) **EP 2 728 257 B1**
(45) Date of publication and mention of the grant of the patent: **06.01.2021**
(21) Application number: 13191339.4
(22) Date of filing: 04.11.2013
(51) Int. Cl.: G01R 31/52

(54) **Glow plug inspecting method, glow plug manufacturing method, sheathed heater inspecting method, and sheathed heater manufacturing method**
Glühkerzeninspektionsverfahren, Glühkerzenherstellungsverfahren, Verfahren zur Inspektion eines ummantelten Heizelements und Verfahren zur Herstellung eines ummantelten Heizelements
Procédé d'inspection et de fabrication de bougie de préchauffage, procédé d'inspection et de fabrication d'un dispositif chauffant gainé

(30) Priority: 01.11.2012 JP 2012241607; 26.08.2013 JP 2013175027
(43) Date of publication of application: 07.05.2014
(73) Proprietor: NGK SPARK PLUG CO., LTD., Nagoya-shi, Aichi 467-8525 (JP)
(72) Inventor: Kumada, Chiaki, Gifu-ken, Gifu (JP); Gotoh, Shunsuke, Aichi-ken, Aichi (JP)
(74) Representative: Grünecker Patent- und Rechtsanwälte PartG mbB

(56) References cited:
- EP-A2- 0 950 858
- WO-A1-2012/073534
- JP-A- 2010 085 058
- US-A- 4 458 639
- US-A- 5 122 968

## Description

### BACKGROUND

### 1. Field of the Invention

The present invention relates to a short circuit abnormality inspection method for a glow plug or a sheathed heater used for pre-heating a diesel engine.

### 2. Description of the Related Art

Conventionally, a glow plug is used to assist the starting of an internal combustion engine, such as a diesel engine. The glow plug includes a metal tubular member with an axial hole extending in an axial line direction, a heater member partially inserted into the axial hole, and an energization member inserted into the axial hole and providing an energization path to the heater member (see, for example, JP-A-2006-302872). As the heater member, a sheathed heater or a ceramic heater may be adopted. The sheathed heater includes a metal heating unit (coil unit) disposed in a tubular metal housing (tube). The metal heating unit can be heated by energizing via the energization member. On the other hand, the ceramic heater includes a heating unit disposed in an insulating ceramic housing. The heating unit is made of electrically conductive ceramic and can be heated by energizing via the energization member. Furthermore, a gap or the like is formed between the tubular member and the energization member disposed on the inner periphery of the tubular member. The gap or the like prevents direct electrical conduction between the tubular member and the energization member. In the sheathed heater, for example, insulating powder is disposed between the inner periphery of the housing and the outer periphery of the heating unit to prevent direct electrical conduction.

A short circuit may develop between the tubular member and the energization member or between the housing and the heating unit. The short circuit may be caused by inclination of the heating unit with respect to the housing, and intrusion of foreign matter into the tubular member or the housing. In the following description, the tubular member or the housing will be referred to as an "outer disposed member", and the heating unit or the energization member disposed within the outer disposed member will be referred to as an "inner conductor".

The short circuit caused between the inner conductor and the outer disposed member may potentially lead to overheating or damage to the heating unit. Thus, in a glow plug manufacturing process, the presence or absence of a short circuit abnormality between the inner conductor and the outer disposed member is inspected. Meanwhile, in a sheathed heater manufacturing process, the presence or absence of a short circuit between the heating unit (coil unit) and the housing (tube) is inspected. A short circuit abnormality inspection method may involve applying a voltage to the inner conductor (heating unit) from a constant-voltage power supply, and performing a short circuit abnormality inspection based on a current that flows through the inner conductor (heating unit) at the time.

From the viewpoint of increasing the accuracy of detection of short circuit abnormality, an increase in voltage applied to the inner conductor (heating unit) is preferred. However, when a constant-voltage power supply is used, it takes time for the voltage to rise. Thus, when a high voltage is applied to the inner conductor (heating unit), the duration of voltage application becomes relatively long. As a result, the temperature of the inner conductor (heating unit) increases as the voltage is applied. Subsequently, as the temperature increases, the current that flows through the inner conductor varies. Consequently, the accuracy of detection of short circuit abnormality may become insufficient. Further, an extended period of voltage application may damage the inner conductor (heating unit). From EP 0 950 858 A2 there is known a situation wherein a change in the resistant value is used for detecting an abnormality. From JP 2010 085058 A, it is known a method wherein a voltage is applied and the applied voltage is compared with a threshold value.

It is therefore an object of the present invention to provide a method for inspecting a glow plug for the presence of short circuit abnormality in such manner so as to avoid overheating or damage to the glow plug.

More particularly, an object of the present invention is to provide a glow plug inspecting method, a glow plug manufacturing method, a sheathed heater inspecting method, and a sheathed heater manufacturing method. These methods can more reliably suppress damage to the inner conductor (heating unit) by applying a high voltage to an inner conductor (heating unit) for only a short period of time, while increasing the accuracy of detection of short circuit abnormality.

### SUMMARY OF THE INVENTION

The above objects of the invention have been achieved by the following.

First Configuration. The above objects have been achieved by providing, in a first aspect of the invention, a method of inspecting a glow plug according to claim 1, including an inner conductor and an outer disposed member, where the inner conductor includes an electrically conductive heating unit configured to generate heat by energization, and an energization member connected in series with the heating unit to provide an energization path to the heating unit, and the outer disposed member includes a housing configured to house the heating unit therein, and a metal tubular member disposed on an outer periphery of the energization member. The method includes inspecting for the presence of short circuit abnormality between the inner conductor and the outer disposed member based on a value that varies in response to a current that flows through the inner conductor upon application of a high voltage higher than a voltage applied during normal use of the glow plug to the inner conductor for a time short enough to suppress a temperature rise of the inner conductor due to application of the high voltage.

As used herein, the phrase "a value that varies in response to a current that flows through the inner conductor" means the value of a current that flows through the inner conductor. Besides that, it also means the value of a current that flows through a conductor electrically connected to the inner conductor, a value of a voltage applied to the inner conductor, or an input electric power to the inner conductor and the like.

According to the first configuration, the glow plug inspecting method includes applying a high voltage higher than a voltage applied during normal use of the glow plug to the inner conductor for only a short period of time. As a result, the glow plug inspecting method can suppress a temperature rise of the inner conductor caused by application of the high voltage, whereby the accuracy of detection of short circuit abnormality can be increased.

In addition, because a high voltage higher than a voltage applied during normal use of the glow plug (i.e., regular operation for heating a diesel engine prior to start up) is applied to the inner conductor, electrical conduction can result between the inner conductor and the outer disposed member when they are closer to each other than usual (e.g., closer than a specified distance). Thus, the glow plug inspecting method according to the present configuration can detect serious short circuit abnormality (where a short circuit is actually present between the inner conductor and the outer disposed member). Further, the glow plug inspecting method according to the present configuration can detect minor short circuit abnormality (where, although there is no short circuit between the inner conductor and the outer disposed member, they are closer to each other than usual and tend to develop a short circuit therebetween during use). Thus, the glow plug inspecting method according to the present configuration can increase the short circuit abnormality detection accuracy.

Second Configuration. In a preferred embodiment of the first configuration, application of a high voltage comprises application of an electric charge stored in a capacitor to the inner conductor.

According to the second configuration, an electric charge stored in the capacitor is applied to the inner conductor to detect short circuit abnormality. Thus, the high voltage is applied to the inner conductor for only an extremely short period of time. As a result, the temperature rise of the inner conductor caused by the voltage application can be effectively suppressed, and the short circuit abnormality detection accuracy can be increased.

In addition, according to the second configuration, a high voltage higher than the voltage applied during normal use of the glow plug can be easily applied to the inner conductor. Thus, electrical conduction can result between the inner conductor and the outer disposed member when they are closer to each other than usual. Accordingly, the glow plug inspecting method according to the present configuration can further increase the short circuit abnormality detection accuracy.

Further, because the duration of application of the electric charge is extremely short, the development of abnormality in the inner conductor due to application of the electric charge can be reliably prevented.

Third Configuration. In a preferred embodiment of the first or second configurations, the heating unit is a metal coil unit, the housing is a tubular metal tube, and the inspecting for the presence of short circuit abnormality is performed when the coil unit is at normal temperature and when the coil unit is heated by energization.

According to the third configuration, the glow plug inspecting method includes performing the short circuit abnormality inspection both when the coil unit is at normal temperature (for example, ambient or room temperature) and when the coil unit is heated by energization. Namely, the glow plug inspecting method according to the present configuration can perform the inspection even when the coil unit is brought closer to the tube by thermal expansion. Thus, the glow plug inspecting method according to the present configuration can detect minor short circuit abnormality more accurately, whereby the short circuit abnormality detection accuracy can be further increased.

When insulating oil is inadvertently present in the tube, the insulation between the coil unit and the tube can be maintained as long as the coil unit is not heated. However, the oil may be carbonized during use (at high temperature), and a short circuit between the coil unit and the tube may result due to the carbonized oil. In this respect, according to the third configuration, the coil unit is heated during the inspection. Thus, the short circuit abnormality inspection is performed after the oil, if any, in the tube is carbonized. Accordingly, the glow plug inspecting method according to the present configuration can detect short circuit abnormality due to the presence of oil, whereby the detection accuracy can be further increased.

Fourth Configuration. In a preferred embodiment of any one of the first to third configurations, the method of inspecting a glow plug comprises applying the high voltage, which can be an electric charge, to the inner conductor for a time period of 50 ms or less.

According to the fourth configuration, the duration of application of the high voltage by means of, e.g., an electric charge, is extremely short. Thus, the glow plug inspecting method according to the present configuration can further increase the short circuit abnormality detection accuracy, and more effectively prevent the development of an abnormality in the inner conductor due to the electric charge application.

Fifth Configuration. In a preferred embodiment of any one of the first to fourth configurations, the method of inspecting a glow plug comprises inputting an amount of electric power of 10 J or less to the inner conductor.

According to the above configuration, the amount of electric power inputted to the inner conductor is 10 J or less. Thus, the glow plug inspecting method according to the present configuration can more effectively suppress a temperature rise of the inner conductor caused by the application of the high voltage, whereby the short circuit abnormality detection accuracy can be increased.

Sixth Configuration. In a second aspect, the present invention provides a method of manufacturing a glow plug according to claim 1, including an inner conductor and an outer disposed member, where the inner conductor includes an electrically conductive heating unit configured to generate heat by energization, and an energization member connected in series with the heating unit to provide an energization path to the heating unit, and the outer disposed member includes a housing configured to house the heating unit therein, and a metal tubular member disposed on an outer periphery of the energization member. The method includes inspecting for the presence of short circuit abnormality between the inner conductor and the outer disposed member based on a value that varies in response to a current that flows through the inner conductor upon application of a high voltage higher than a voltage applied during normal use of the glow plug to the inner conductor for a time short enough to suppress a temperature rise of the inner conductor due to application of the high voltage.

According to the sixth configuration, an operation and effect similar to the operation and effect of the first configuration are obtained.

Seventh Configuration. In a preferred embodiment of the sixth configuration, the application of a high voltage comprises application of an electric charge stored in a capacitor to the inner conductor.

According to the seventh configuration, the same working effect as with the second configuration is obtained.

Eighth Configuration. In a preferred embodiment of the sixth or seventh configurations, the heating unit is a metal coil unit, the housing is a tubular metal tube, and the inspecting for the presence of short circuit abnormality is performed when the coil unit is at normal temperature and when the coil unit is heated by energization.

According to the eighth configuration, the same working effect as with the third configuration is obtained.

Ninth Configuration. In a preferred embodiment of any one of the sixth to eighth configurations, the short circuit inspection process comprises applying the high voltage, which can be an electric charge, to the inner conductor for a time period of 50 ms or less.

According to the ninth configuration, the same working effect as with the fourth configuration is obtained.

Tenth Configuration. In a preferred embodiment of any one of the sixth to ninth configurations, the method of manufacturing a glow plug comprises inputting an amount of electric power of 10 J or less to the inner conductor.

According to the tenth configuration, the same working effect as with the fifth configuration is obtained.

Eleventh Configuration. In a third aspect, the present invention provides a method of inspecting a sheathed heater according to claim 6, including a metal coil unit configured to generate heat by energization, and a tubular metal tube configured to house the coil unit. The method comprises inspecting for the presence of short circuit abnormality between the coil unit and the tube based on a value that varies in response to a current that flows through the coil unit upon application of a high voltage higher than a voltage applied during normal use of the sheathed heater to the coil unit for a time short enough to suppress a temperature rise of the coil unit due to application of the high voltage.

As used herein, the phrase "a value that varies in response to a current that flows through the coil unit" means the value of a current that flows through the coil unit. In addition, it also means the value of a current that flows through a conductor electrically connected to the coil unit, a value of a voltage applied to the coil unit, an input electric power to the coil unit, and the like.

According to the eleventh configuration, a high voltage higher than a voltage applied during normal use of the sheathed heater is applied to the coil unit for only a short period of time. As a result, the sheathed heater inspecting method according to the present configuration can suppress the temperature rise of coil unit due to application of the high voltage, whereby the accuracy of detection of short circuit abnormality can be increased.

In addition, according to the eleventh configuration, a high voltage higher than the voltage applied during normal use of the sheathed heater is applied to the coil unit. Thus, the sheathed heater inspecting method according to the present configuration can detect serious short circuit abnormality (where a short circuit is actually present between the coil unit and the tube). Further, the sheathed heater inspecting method according to the present configuration can detect minor short circuit abnormality (where, although there is no short circuit between the coil unit and the tube, they are closer to each other than usual and tend to develop a short circuit therebetween during use). Accordingly, the sheathed heater inspecting method according to the present configuration can further increase the accuracy of detection of short circuit abnormality.

Twelfth Configuration. In a preferred embodiment of the eleventh configuration, the application of a high voltage comprises application of an electric charge stored in a capacitor to the coil unit.

According to the twelfth configuration, a high voltage is applied to the coil unit for only an extremely short period of time. Thus, the sheathed heater inspecting method according to the present configuration can effectively suppress a temperature rise of the coil unit due to voltage application. As a result, the sheathed heater inspecting method according to the present configuration can increase the short circuit abnormality detection accuracy.

Further, according to the twelfth configuration, a high voltage higher than the voltage applied during normal use of the sheathed heater can be easily applied. Thus, the sheathed heater inspecting method according to the present configuration can further increase the short circuit abnormality detection accuracy.

Further, because the duration of application of an electric charge is extremely short, the development of an abnormality in the coil unit due to application of the electric charge can be more reliably prevented.

Thirteenth Configuration. In a preferred embodiment of the eleventh or twelfth configurations, the inspecting for the presence of short circuit abnormality is performed when the coil unit is at normal temperature and the coil unit is heated by energization.

According to the thirteenth configuration, the same working effect as with the third configuration is obtained.

Fourteenth Configuration. In a preferred embodiment of any one of the eleventh to thirteenth configurations, the method of inspecting a sheathed heater comprises applying the high voltage, which can be an electric charge, to the coil unit for 50 ms or less.

According to the fourteenth configuration, the same working effect as with the fourth configuration is obtained.

Fifteenth Configuration. In a preferred embodiment of any one of the eleventh to fourteenth configurations, the method of inspecting a sheathed heater comprises inputting an amount of electric power of 10 J or less to the coil unit.

According to the fifteenth configuration, the same working effect as with the fifth configuration is obtained.

Sixteenth Configuration. In a fourth embodiment, the present invention provides a method of manufacturing a sheathed heater according to claim 6, including a metal coil unit configured to generate heat by energization, and a tubular metal tube configured to house the coil unit. The method includes inspecting for the presence of short circuit abnormality between the coil unit and the tube based on a value that varies in response to a current that flows through the coil unit upon application of a high voltage higher than a voltage applied during normal use of the sheathed heater to the coil unit for a time short enough to suppress a temperature rise of the coil unit due to application of the high voltage.

According to the sixteenth configuration, the same working effect as with the eleventh configuration is obtained.

Seventeenth Configuration. In a preferred embodiment of the sixteenth configuration, the application of a high voltage comprises application of an electric charge stored in a capacitor to the coil unit.

According to the seventeenth configuration, the same working effect as with the twelfth configuration is obtained.

Eighteenth Configuration. In a preferred embodiment of the sixteenth or seventeenth configurations, the inspecting for the presence of short circuit abnormality is performed when the coil unit is at normal temperature and when the coil unit is heated by energization.

According to the eighteenth configuration, the same working effect as with the third configuration is obtained.

Nineteenth Configuration. In a preferred embodiment of any one of the sixteenth to eighteenth configurations, the method of manufacturing a sheathed heater comprises applying the high voltage, which can be an electric charge, to the coil unit for a time period of 50 ms or less.

According to the nineteenth configuration, the same working effect as with the fourth configuration is obtained.

Twentieth Configuration. In a preferred embodiment of any one of the sixteenth to nineteenth configurations, the method of manufacturing a sheathed heater, comprises inputting an amount of electric power of 10 J or less to the coil unit.

According to the twentieth configuration, the same working effect as with the fifth configuration is obtained.

### BRIEF DESCRIPTION OF THE DRAWINGS

FIGS. 1A and 1B are diagrams illustrating the configuration of a glow plug where FIG. 1A is a partially fractured front view of the glow plug and FIG. 1B is an enlarged cross sectional view of a front-end portion of the glow plug.
FIG. 2 is a block diagram illustrating a schematic configuration of an inspection apparatus.
FIG. 3 is a partially fractured front view illustrating a step of a short circuit inspection process.
FIG. 4 is a graphical representation of the transition of current that flows through an inner conductor in the presence of short circuit abnormality and in the absence of short circuit abnormality.
FIG. 5 is a graphical representation of the relationship between the amount of input electric power and the temperature of the glow plug after a short circuit test.
FIG. 6 is a partially fractured front view illustrating a step of the short circuit inspection process in a sheathed heater.

### DESCRIPTION OF THE PREFERRED EMBODIMENTS

In the following detailed description, for purpose of explanation, numerous specific details are set forth in order to provide a thorough understanding of the disclosed embodiments. However, the present invention should not be construed as being limited thereto. It will be apparent, however, that one or more embodiments may be practiced without these specific details. In other instances, well-known structures and devices are schematically shown in order to simplify the drawing.

Further, in the following, a glow plug inspecting method, a glow plug manufacturing method, a sheathed heater inspecting method, and a sheathed heater manufacturing method suitable for achieving the above object will be described on an item-by-item basis. The working effects unique to corresponding configurations will be described as needed.

In the following, an embodiment of the present invention will be described with reference to the drawings. Before a description of an inspecting method (manufacturing method) according to the embodiment of the present invention, a configuration of a sheathed heater 5 and a glow plug 1 including the sheathed heater 5 as the object of inspection (object of manufacture) will be described.

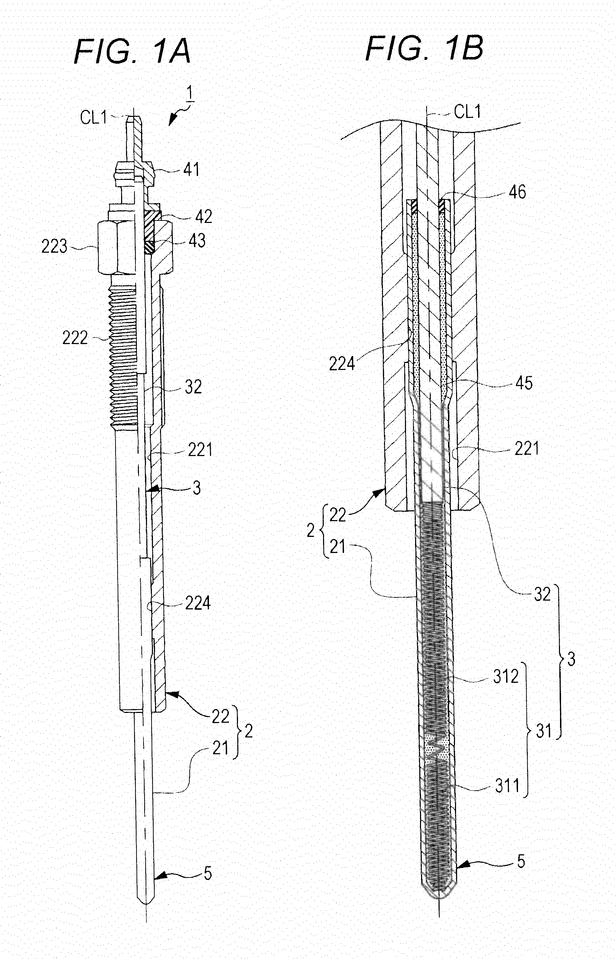

FIGS. 1A and 1B illustrate a configuration of the glow plug 1. FIG. 1A shows a partially fractured front view of the glow plug. FIG. 1B illustrates an enlarged cross sectional view of a front-end portion of the glow plug 1. The glow plug 1 has an axial line CL1. In the following description, the direction of CL1 corresponds to a top-bottom direction of the drawing sheet, with the bottom side corresponding to a front-end side of the glow plug 1 and the top side corresponding to a rear end side.

As illustrated in FIGS. 1A and 1B, the glow plug 1 includes an outer disposed member 2, and an inner conductor 3 disposed within the outer disposed member 2.

The outer disposed member 2 includes a tube 21 (corresponding to a "housing" of the present invention) and a metal housing 22 (corresponding to a "tubular member" of the present invention). The tube 21 houses a coil unit 31 (corresponding to a "heating unit" of the present invention), described below. The housing 22 is disposed on an outer periphery of a center pole 32 (corresponding to an "energization member" of the present invention), described below.

The tube 21 contains a predetermined metal (such as a metal containing Fe or Ni as a principal component) and has a tubular shape with a closed front-end portion.

The housing 22 has an axial hole 221 extending in the direction of the axial line CL1. The housing 22 has an outer peripheral surface with a threaded portion 222 and a tool-engaging portion 223. The threaded portion 222 is threadedly engaged with a mount hole of an engine head when the glow plug 1 is mounted to the engine head of an internal combustion engine (such as a diesel engine). The tool-engaging portion 223 has a hexagonal cross section for engaging with a tool, such as a torque wrench.

In addition, the housing 22 includes a holding portion 224 protruding from an inner periphery on the front-end side toward the inner periphery side. The tube 21 is press-fit into the holding portion 224, with the front-end portion of the tube 21 protruding from the front end of the housing 22. Thus, the tube 21 is held by the housing 22.

The inner conductor 3 includes the coil unit 31 and the center pole 32. The coil unit 31 functions as a heating unit. The center pole 32 is connected in series with the coil unit 31 and functions as an energization member providing an energization path to the coil unit 31.

The coil unit 31 includes a heating coil 311 and a control coil 312 directly connected with the heating coil 311. The control coil 312 is connected to the center pole 32 by resistance welding and the like. The heating coil 311 includes a spirally wound electrically heated wire. The electrically heated wire contains a predetermined metal (such as an alloy of Fe as a principal component and A1 or Cr and the like). The heating coil 311 includes a front-end portion welded to a front-end portion of the tube 21.

The control coil 312 includes a spirally wound resistive heating wire. The material of the resistive heating wire has a temperature coefficient of electrical resistivity greater than the temperature coefficient of electrical resistivity of the material of the heating coil 311. The material includes, for example, a metal containing Co or Ni as a principal component. Thus, the electrical resistance value of the control coil 312 increases when subjected to the heat generated by itself and the heat generated by the heating coil 311. The control coil 312 therefore controls the amount of electric power supplied to the heating coil 311. Namely, during the initial period of energization, the heating coil 311 is supplied with a relatively large electric power, so that the temperature of the heating coil 311 rapidly increases. As a result, the control coil 312 is heated by the heat generated by the heating coil 311. As its temperature increases, the electrical resistance of the control coil 312 increases, causing a decrease in electric power supplied to the heating coil 311 and the like. Thus, the heating coil 311 has temperature rise characteristics such that the temperature rapidly increases in the initial period of energization, and is then saturated as the electric power supply is suppressed by the action of the control coil 312. In other words, the control coil 312 enhances the rapid temperature rise characteristics of the heating coil 311, and makes it difficult for the heating coil 311 to exhibit an excessive temperature rise (overshoot).

The center pole 32 has the shape of a bar extending along the direction of the axial line CL1. The center pole 32 is inserted into the axial hole 221. The center pole 32 is made of a predetermined electrically conductive metal. The center pole 32 includes a front-end portion inserted into the tube 21 and joined to a rear end portion of the control coil 312.

In addition, the center pole 32 includes a rear end portion protruding from the rear end of the housing 22. On the rear end portion of the center pole 32, a bottomed tubular terminal pin 41 for cable connection is fixed by crimping. Thus, by applying a voltage to the terminal pin 41, the voltage can be applied to the coil unit 31 via the center pole 32.

Between the front-end portion of the terminal pin 41 and the rear end portion of the housing 22, a tubular insulating bushing 42 made of an insulating material is disposed to prevent direct electrical conduction (short circuit) between the terminal pin 41 and the housing 22. In addition, between the housing 22 and the center pole 32, a ring-shaped sealing member 43 made of an insulating material is disposed in contact with the front-end portion of the insulating bush 42 to improve airtightness within the axial hole 221. Because of the presence of the insulating bush 42 and the like and a gap formed between the outer periphery of the center pole 32 and the inner periphery of the housing 22, direct electrical conduction between the center pole 32 and the housing 22 is prevented.

Further, inside the tube 21, an insulating powder 45 of magnesium oxide (MgO) as a principal component is hermetically contained. Thus, the outer peripheral surface of the coil unit 31 and the inner peripheral surface of the tube 21 are insulated from each other by the interposed insulating powder 45. In addition, a gap between the rear end of the tube 21 and the center pole 32 is sealed by a ring-shaped rubber grommet 46. According to the present embodiment, furthermore, the sheathed heater 5 includes the tube 21, and the coil unit 31 and the insulating powder 45 disposed in the tube 21.

Next, a short circuit inspection process as part of the method of manufacturing the glow plug 1 will be described. The short circuit inspection process, which is included in the manufacturing process for the glow plug 1, is a process of inspecting for the presence of short circuit abnormality between the outer disposed member 2 and the inner conductor 3. An inspection apparatus 7 used in the short circuit inspection process and the details of the short circuit inspection process will be described as follows.

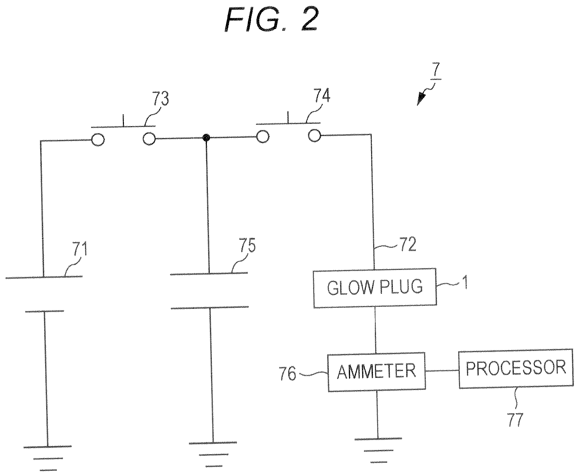

As illustrated in FIG. 2, the inspection apparatus 7 includes a power source 71, a first switch 73, a second switch 74, and a capacitor 75. The power source 71 can be connected in series with the glow plug 1. The first switch 73 and the second switch 74 are disposed between the power source 71 and a connecting terminal 72 connected to the glow plug 1, and are mutually connected (for example, the switches 73 and 74 are FETs). The capacitor 75 is connected in parallel with the power source 71, with one end connected between the switches 73 and 74. Accordingly, the electrostatic capacitance of the capacitor 75 is set to be not less than a predetermined value (such as 5000 µF). Between the capacitor 75 and the glow plug 1 (connecting terminal 72), no element other than the second switch 74 is disposed. Namely, the inspection apparatus 7 is configured such that when the second switch 74 is on, the resistance value between the capacitor 75 and the glow plug 1 (connecting terminal 72) becomes extremely small (such as not more than 3 mΩ, or substantially zero).

The inspection apparatus 7 further includes an ammeter 76 and a processor 77. The ammeter 76 can measure the current value of a current that flows through the inner conductor 3. The current value measured by the ammeter 76 is inputted to the processor 77. The processor 77 includes a CPU and a storage device, such as a RAM, and determines the presence or absence of short circuit abnormality between the outer disposed member 2 and the inner conductor 3, based on the input current value. The "short circuit abnormality" is not limited to the case where the inner conductor 3 and the outer disposed member 2 are, e.g., in physical contact with each other and a short circuit is actually present. The term "short circuit abnormality" includes the following case: Electrical conduction can be established (discharge) between the inner conductor 3 and the outer disposed member 2 when the inner conductor 3 and the outer disposed member 2 are so close to each other such that a high voltage applied to the inner conductor 3 is discharged to the outer disposed member 2 (i.e., when a short circuit can readily result between the inner conductor 3 and the outer disposed member 2 during use).

Further, the processor 77 measures the time (decay time) between the input of a current value of a preset predetermined value or more and the decaying of the current value below a preset, predetermined current threshold value. When the measured decay time is not more than a preset reference time, the processor 77 determines that there is a short circuit abnormality between the outer disposed member 2 and the inner conductor 3. On the other hand, when the measured decay time exceeds the reference time, the processor 77 determines that there is no short circuit abnormality between the outer disposed member 2 and the inner conductor 3.

Next, a short circuit inspection process will be described. According to the present embodiment, the short circuit inspection process is performed both when the coil unit 31 is at normal temperature and when the coil unit 31 is heated by energization. The short circuit inspection process includes a first short circuit inspection process performed when the coil unit 31 is at normal temperature, and a second short circuit inspection process performed when the coil unit 31 is heated after the first short circuit inspection process.

The first short circuit inspection process turns the second switch 74 off and then turns the first switch 73 on to allow the capacitor 75 to store electric charge from the power source 71.

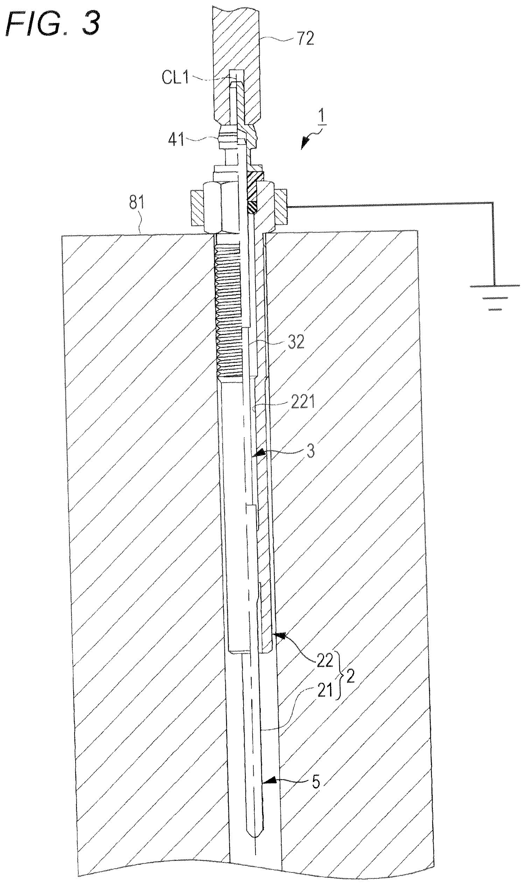

Then, as illustrated in FIG. 3, the glow plug 1 is placed on a predetermined receiving base 81. The connecting terminal 72 is attached to the terminal pin 41 of the glow plug 1, and the housing 22 is connected to ground. Thus, in the absence of a short circuit abnormality between the outer disposed member 2 and the inner conductor 3, an electroconductive path is formed between the connecting terminal 72 and ground via the terminal pin 41, the inner conductor 3 (the center pole 32 and the coil unit 31), and the outer disposed member 2 (the tube 21 and the housing 22).

After the connecting terminal 72 is attached to the glow plug 1, the first switch 73 is turned off and the second switch 74 is turned on. Thereby, the electric charge stored in the capacitor 75 is applied to the inner conductor 3 (the center pole 32 and the coil unit 31). As a result, a high voltage is applied to the inner conductor 3 in a short time. The current value of the current that flows through the inner conductor 3 is measured by the ammeter 76, and the measured current value is inputted to the processor 77. Accordingly, no element other than the second switch 74 is disposed between the capacitor 75 and the glow plug 1. Thus, the duration of application of the electric charge from the capacitor 75 to the inner conductor 3 is very short (specifically, 50 ms or less). As described above, the electrostatic capacitance of the capacitor 75 is set to be not less than a predetermined value (such as 5000 µF). As a result, the applied voltage to the inner conductor 3 is not less than a predetermined value (such as 30 V; 50 V according to the present embodiment). The amount of electric power inputted from the capacitor 75 to the inner conductor 3 is 10 J or less.

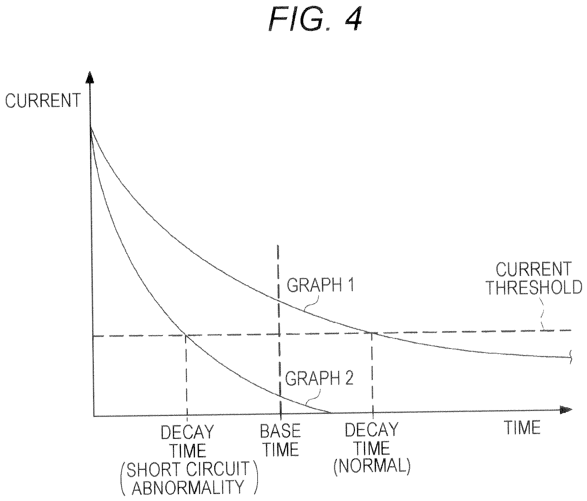

When the current value is inputted, the processor 77 determines the presence or absence of a short circuit abnormality based on the input current value. Namely, when the decay time is more than the reference time, the processor 77 determines that there is no short circuit abnormality. This is because of the fact that, in the absence of a short circuit abnormality, the resistance value between the connecting terminal 72 and ground is relatively large, so that the input current value decays gradually, as indicated by graph 1 in FIG. 4.

On the other hand, when the decay time is not more than the reference time, the processor 77 determines that there is a short circuit abnormality. This is because of the fact that, in the presence of short circuit abnormality, the resistance value between the connecting terminal 72 and ground becomes relatively small, so that the input current value sharply decays, as indicated by graph 2 in FIG. 4.

After the first short circuit inspection process, the second short circuit inspection process is performed, in which the coil unit 31 is heated and the presence or absence of a short circuit abnormality is determined. Specifically, a voltage of a predetermined value (such as 4 V to 13 V) is applied to the coil unit 31 for a predetermined time (such as 10 s to 50 s) so as to heat the coil unit 31. The heating allows the coil unit 31 to thermally expand and approach the inner peripheral surface of the tube 21. Further, electric charge from the capacitor 75 is applied to the inner conductor 3 by the same method as described above, and then the presence or absence of a short circuit abnormality is inspected by the processor 77.

As described above, the inspection apparatus 7 and the short circuit inspection process using the inspection apparatus 7 can inspect for the presence of short circuit abnormality by applying the electric charge stored in the capacitor 75 to the inner conductor 3. This allows a high voltage to be applied to the inner conductor 3 for only an extremely short period of time. As a result, an increase in temperature of the inner conductor 3 due to application of the high voltage can be suppressed, whereby the short circuit abnormality detection accuracy can be increased.

In addition, a voltage higher than a voltage applied during normal use of the glow plug 1 (such as not less than 4 V and not more than 13 V) can be easily applied. Thus, when the inner conductor 3 and the outer disposed member 2 are closer to each other than usual, electrical conduction can result between the inner conductor 3 and the outer disposed member 2. It is therefore possible to detect not just serious short circuit abnormality (where an actual short circuit is present between the inner conductor 3 and the outer disposed member 2), but also minor short circuit abnormality (where, although a short circuit is not present between the inner conductor 3 and the outer disposed member 2, they are closer to each other than usual and tend to develop a short circuit therebetween during use). Thus, the short circuit abnormality detection accuracy can be further increased.

According to the present embodiment, the duration of application of electric charge is extremely short. Thus, the development of abnormality in the inner conductor 3 due to the application of the electric charge can be prevented more reliably.

Accordingly, each of the inspection apparatus 7 and the short circuit inspection process using the inspection apparatus 7 performs the short circuit abnormality inspection when the coil unit 31 is at normal temperature and when the coil unit 31 is heated by energization. Namely, the inspection is also performed when the coil unit 31 is brought closer to the tube 21 due to thermal expansion. Thus, minor short circuit abnormality can be more accurately detected. As a result, the short circuit abnormality detection accuracy can be further increased.

Further, according to the present embodiment, the coil unit 31 is heated during the inspection. Thus, when oil is present within the tube 21, the short circuit abnormality inspection is performed after the oil is carbonized. Accordingly, short circuit abnormality due to the presence of oil can be detected. As a result, the short circuit abnormality detection accuracy can be further increased.

In addition, according to the present embodiment, the duration of application of electric charge to the inner conductor 3 is set to be 50 ms or less. Namely, the duration of application of electric charge is extremely short. Thus, the short circuit abnormality detection accuracy can be further increased. Further, the development of an abnormality in the inner conductor 3 due to the application of electric charge can be prevented more effectively.

The voltage applied from the capacitor 75 to the inner conductor 3 is not less than 50 V. Thus, minor short circuit abnormality can be detected more accurately.

According to the present embodiment, the amount of electric power inputted from the capacitor 75 to the inner conductor 3 is 10 J or less. Thus, an increase in temperature of the inner conductor 3 due to the application of voltage (electric charge) can be suppressed more effectively. As a result, the detection accuracy can be increased.

A test for confirming short circuit detection accuracy was performed to confirm the operation. The outline of the test for confirming short circuit detection accuracy is as follows: One thousand samples of the glow plug were manufactured, in which the coil unit was made eccentric with respect to the tube so that a short circuit abnormality between the tube and the coil unit would tend to result. The samples were subjected to a short circuit abnormality inspection according to the first to fourth inspection methods described below, and the rate of detection of short circuit abnormality was measured. The higher the short circuit abnormality detection rate, the more readily minor short circuit abnormality as well as serious short circuit abnormalities can be detected. The "serious short circuit abnormality" herein refers to a state in which the coil unit and the tube are in an actual short-circuit condition. The term "minor short circuit abnormality" used herein refers to, for example, any of the following states: A first state is one in which the coil unit and the tube are not short-circuited but are so close to each other that a short circuit can develop by thermal expansion or the like of the coil unit during use. Another state is one in which there is oil in the tube so that the coil unit and the tube can short-circuit by carbonization of the oil during use.

Then, in each method, eight samples in which no short circuit abnormality was detected were extracted. Then, the eight samples were subjected to a durability test to measure the number of coil units exhibiting disconnection in the durability test (number of disconnected coils). In the durability test, a cycle of voltage application of 11 V for five seconds and then a voltage application of 13 V for 180 seconds, followed by cooling by air, was repeated 5000 times. That is, the phrase "the coil unit was subject to disconnection" means that "although a short circuit abnormality was actually present in the sample, the abnormality was not detected by the short circuit abnormality inspection". Namely, the inspection method implemented on the sample subject to disconnection may be said to have an inferior detection accuracy. Meanwhile, "the coil unit was not subject to disconnection" means that the sample exhibiting short circuit abnormality in the inspection was accurately detected, and the inspection method used may be said to have superior detection accuracy.

In the first inspection method, a voltage of 50 V was applied to the inner conductor (coil unit) at normal temperature from a constant-voltage power supply. Based on the current value of a current flow through the inner conductor, a short circuit abnormality was detected. Namely, the first inspection method is a method according to the conventional art, and corresponds to a comparative example.

In the second inspection method, the electric charge stored in a capacitor was applied to the inner conductor (coil unit) at normal temperature, whereby a voltage of 30 V was applied to the inner conductor. Based on the current value of a current flow through the inner conductor, a short circuit abnormality was detected. Namely, the second inspection method corresponds to an example of the present embodiment.

In the third inspection method, the electric charge stored in the capacitor was applied to the inner conductor (coil unit) at normal temperature, whereby a voltage of 50 V was applied to the inner conductor. Based on the current value of a current flow through the inner conductor, a short circuit abnormality was detected. The third inspection method corresponds to another example of the present embodiment.

In the fourth inspection method, the electric charge stored in the capacitor was applied to the inner conductor both when the inner conductor (coil unit) was at normal temperature and when the coil unit was heated by the energization. Thereby, a voltage of 50 V was applied to the inner conductor. Based on the current value of a current flow through the inner conductor, a short circuit abnormality was detected. The fourth inspection method corresponds to yet another example of the present embodiment.

Table 1 shows the detection rate and the number of disconnected coils resulting in each inspection method. For reference, Table 1 also shows the number of disconnected coils resulting in a case where the durability test was performed on samples that were not subjected to the short circuit abnormality inspection.

**Table 1**

| | Detection rate | Number of disconnected coils |
|---|---|---|
| No inspection | 0% | 2 |
| First inspection method | 10% | 1 |
| Second inspection method | 15% | 0 |
| Third inspection method | 18% | 0 |
| Fourth inspection method | 20% | 0 |

As shown in Table 1, in the second to fourth inspection methods involving the application of an electric charge from the capacitor, the number of disconnected coils was zero, indicating that these methods have superior detection accuracy. This is believed due to the extremely short voltage application time. Namely, this is believed due to the fact that, as the temperature rise of the inner conductor (coil unit) due to the application of voltage is almost eliminated, current variations due to temperature variations hardly occur.

Further, in the fourth inspection method, the short circuit abnormality inspection was also performed when the coil unit was heated, in addition to when the inner conductor was at normal temperature. As a result, the detection rate was considerably increased, indicating that a minor short circuit abnormality can also be accurately detected.

It was also confirmed that the accuracy of detection of short circuit abnormality can be further increased by setting the voltage applied to the inner conductor 50 V or higher.

As is evident from the results of the above test, in order to increase the short circuit abnormality detection accuracy, it is preferable to apply the electric charge stored in the capacitor to the inner conductor, and perform the short circuit abnormality inspection based on a value that varies in response to the current that flows through the inner conductor.

From the viewpoint of further increasing the detection accuracy, it is preferable to conduct the short circuit abnormality inspection both when the coil unit is at normal temperature and when the coil unit is heated by the energization.

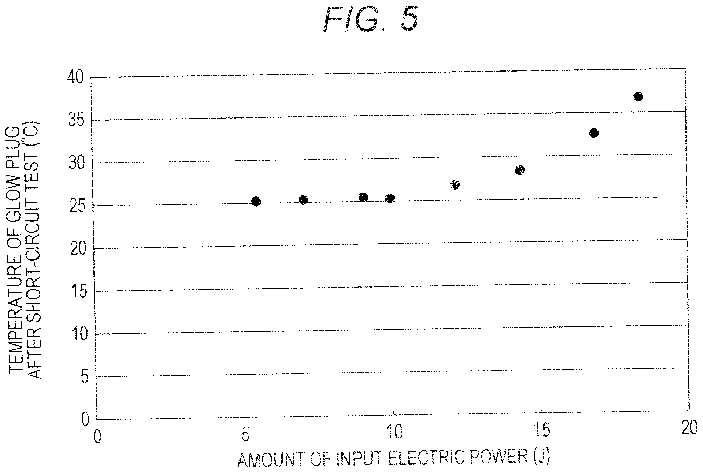

Next, a short circuit test was performed while varying the amount of input electric power to the glow plug (inner conductor), and the temperature of the glow plug with respect to the amount of input electric power was measured after the short circuit test. Specifically, the short circuit test was performed while varying the amount of input electric power to the glow plug maintained at room temperature (25°C). The temperature of the glow plug (outer surface temperature of the tube) after the short circuit test was measured with a radiation thermometer. FIG. 5 is a graphical representation of the relationship between the amount of input electric power and the temperature of the glow plug after the short circuit test.

As illustrated in FIG. 5, when the amount of input electric power is 10 J or less, the temperature of the glow plug after the short circuit test was the same as before the short circuit test. Thus, it makes clear that the temperature rise of the glow plug (inner conductor) due to application of voltage (electric charge) during the short circuit test can be suppressed more effectively.

The present invention is not limited to the specifics of the above embodiment, and may be implemented, for example, as described below. It should be apparent that applications and modifications other than those described below by way of example are also possible.

(a) The configuration of the glow plug 1 according to the above embodiment is merely an example, and the glow plug to which the present invention is applicable is not limited to the above embodiment but by the wording of claims 1 and 6. Thus, the center pole 32 may be directly connected to the heating coil 311, and the control coil 312 may be omitted. The technical concept of the present invention may be applied to a ceramic glow plug having a ceramic heater described below. The ceramics heater includes an insulating ceramic tubular base member (corresponding to the "housing" according to the present invention), and a heating element (corresponding to the "heating unit" according to the present invention) disposed in the base member and formed of an electrically conductive ceramic, the heating element generating heat by energization via the center pole 32. Further, the shape of the sheathed heater or the ceramic heater is not particularly limited. For example, the sheathed heater or the ceramic heater may have an elliptical, oval, or polygonal cross sectional shape. In addition, the heater may be a so-called planar heater including a plurality of plate-shaped insulating base members and a heating unit sandwiched between the base members.

When the technical concept of the present invention is applied to a ceramic glow plug, no short circuit is caused between the base member and the heating element because the base member is insulating. Thus, short circuit abnormality between the center pole 32 and the housing 22 is inspected by the short circuit abnormality inspection.

(b) In the above embodiment, the short circuit inspection process includes the first short circuit inspection process is performed when the coil unit 31 is at normal temperature, and the second short circuit inspection process performed when the coil unit 31 is heated. However, the present invention is not limited to the above embodiment. The short circuit inspection process may include one of the processes.

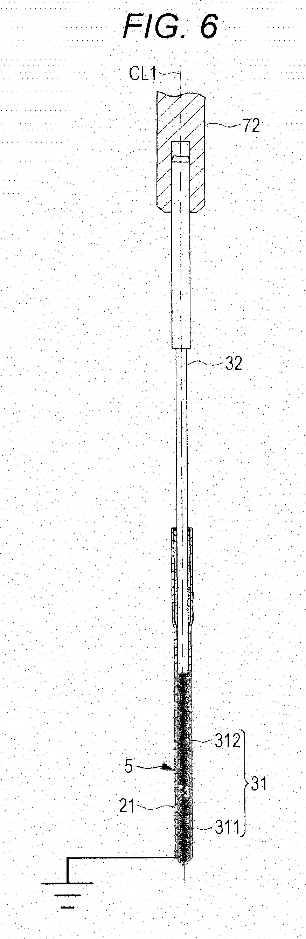

(c) In the above embodiment, the glow plug 1 is the object of inspection. However, the present disclosure is not limited to such an embodiment. The object of inspection may be the sheathed heater 5. Namely, the short circuit abnormality inspection may be performed between the tube 21 and the coil unit 31. In this case, as illustrated in FIG. 6, the tube 21 is connected to ground. Then, the electric charge stored in the capacitor 75 is applied to the coil unit 31 for a time period of only 50 ms or less. Then, the presence or absence of short circuit abnormality between the tube 21 and the coil unit 31 is inspected based on a value that varies in response to a current that flows through the coil unit 31 upon application of the electric charge. In this case, a high voltage is applied to the coil unit 31 for only an extremely short time. Thus, the temperature rise of the coil unit 31 due to application of the voltage can be suppressed. As a result, the accuracy of detection of the presence of a short circuit abnormality can be increased.

In addition, a voltage higher than a voltage applied during normal use of the sheathed heater 5 (such as a voltage not less than 4 V and not more than 13 V) can be easily applied to the coil unit 31. Thus, a serious short circuit abnormality (where short circuit is actually present between the coil unit 31 and the tube 21) can be detected. Further, a minor short circuit abnormality (where, although there is no short circuit between the coil unit 31 and the tube 21, they are closer to each other than usual and tend to develop a short circuit therebetween during use) can also be detected. Accordingly, the accuracy of detecting the presence of a short circuit abnormality can be further increased.

Further, the duration of application of electric charge to the coil unit 31 is extremely short. Thus, the development of abnormality in the coil unit 31 due to application of an electric charge can be prevented more reliably.

The amount of electric power inputted from the capacitor 75 to the coil unit 31 is 10 J or less. Thus, the temperature rise of the coil unit 31 caused by the application of voltage (electric charge) can be suppressed more effectively. As a result, the detection accuracy can be increased.

The short circuit abnormality inspection on the sheathed heater 5 is able to be performed when the coil unit 31 is at normal temperature only. Alternatively, the inspection may be performed both when the coil unit 31 is at normal temperature and when the coil unit 31 is heated by energization.

(d) In the above embodiment, the short circuit abnormality inspection is performed based on a current value of the current that flows through the inner conductor 3 or the coil unit 31. However, the present invention is not limited to such an embodiment. For example, the short circuit abnormality inspection is performed based on a value that varies in response to the current that flows through the inner conductor 3 or the coil unit 31 (such as a voltage value of a voltage applied to the inner conductor 3 and the like, or an input electric power to the inner conductor 3 and the like).

(e) According to the above embodiment, as a means for applying a high voltage to the inner conductor 3 (coil unit 31) for only a short time, the capacitor 75 is used. However, the present invention is not limited to such embodiment. For example, instead of the capacitor 75, a pulse power source and the like that can apply a high voltage for a short period of time only may be used.

The foregoing detailed description has been presented for the purposes of illustration and description. Many modifications and variations are possible in light of the above teaching. It is not intended to be exhaustive or to limit the subject matter described herein to the precise form disclosed, the invention is limited only by the wordings of the appended claims. Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims appended hereto.

## Claims

1. A method of manufacturing and/or inspecting a glow plug (1) including an inner conductor (3) and an outer disposed member (2), where
the inner conductor (3) includes an electrically conductive heating unit (31) configured to generate heat by energization, and an energization member (32) connected in series with the heating unit (31) to provide an energization path to the heating unit (31), and
the outer disposed member (2) includes a housing (21) configured to house the heating unit (31) therein, and a metal tubular member (22) disposed on an outer periphery of the energization member (32); wherein the heating unit (31) is a metal coil unit
the method comprises:
inspecting for the presence of short circuit abnormality between the inner conductor (3) and the outer disposed member (2) based on a decay time between the input of a current value of a preset predetermined value or more and the decaying of the current value below of predetermined current threshold value, wherein the current value is supplied by a current that flows through the inner conductor (3) upon application of a high voltage higher than a voltage applied during normal use of the glow plug (1) to the inner conductor (3) for a time short enough to suppress a temperature rise of the inner conductor (3) due to application of the high voltage,
wherein the inspection is carried out when the coil unit is at a ambient temperature,
wherein it is determined with a processor (77) whether the decay time is more than a reference time, and in the case the decay time is not more than the reference value it is determined that there is a short circuit abnomality.

2. The method according to claim 1, wherein said application of a high voltage comprises application of an electric charge stored in a capacitor (75) to the inner conductor (3).

3. The method according to claim 1 or 2, wherein
the housing (21) is a tubular metal tube, and
additionally said inspecting for the presence of short circuit abnormality is performed when the coil unit (31) is heated by energization.

4. The method according to any one of claims 1 to 3, which comprises applying the high voltage to the inner conductor (3) for a timer period of 50 ms or less.

5. The method according to any one of claims 1 to 4, which comprises inputting an amount of electric energy of 10 J or less to the inner conductor (3).

6. A method of manufacturing and/or inspecting a sheathed heater (5) including a metal coil unit (31) configured to generate heat by energization, and a tubular metal tube (21) configured to house the coil unit (31),
**characterized in that**
the method comprises inspecting for the presence of short circuit abnormality between the coil unit (31) and the tube (21) based on a decay time between the input of a current value of a preset predetermined value or more and the decaying of the current value below of predetermined current threshold value, wherein the current value is supplied by a current that flows through the coil unit (31) upon application of a high voltage higher than a voltage applied during normal use of the sheathed heater (5) to the coil unit (31) for a time short enough to suppress a temperature rise of the coil unit (31) due to application of the high voltage, wherein the inspection is carried out when the coil unit is at an ambient temperature,
wherein it is determined with a processor (77) whether the decay time is more than a reference time, and in the case the decay time is not more than the reference value it is determined that there is a short circuit abnomality.

7. The method according to claim 6, wherein said application of a high voltage comprises application of an electric charge stored in a capacitor (75) to the coil unit (31).

8. The method according to claim 6 or 7, wherein said inspecting for the presence of short circuit abnormality is additionally performed when the coil unit (31) is heated by energization.

9. The method according to any one of claims 6 to 8, which comprises applying the high voltage to the coil unit (31) for a time period of 50 ms or less.

10. The method according to any one of claims 6 to 9, which comprises inputting an amount of electric energy of 10 J or less to the coil unit (31).

## Patentansprüche

1. Verfahren zur Herstellung und/oder Prüfung einer Glühkerze (1) mit einem Innenleiter (3) und einem außen angeordneten Element (2), wobei
der Innenleiter (3) eine elektrisch leitende Heizeinheit (31) enthält, die so konfiguriert ist, dass sie durch Erregung Wärme erzeugt, und ein Erregungselement (32), das mit der Heizeinheit (31) in Reihe geschaltet ist, um einen Erregungspfad zu der Heizeinheit (31) bereitzustellen, und
das außen angeordnete Element (2) ein Gehäuse (21), das so konfiguriert ist, dass es die Heizeinheit (31) darin aufnimmt, und ein metallisches röhrenförmiges Element (22) umfasst, das an einem Außenumfang des Erregungselements (32) angeordnet ist; wobei die Heizeinheit (31) eine Metallspuleneinheit ist
das Verfahren umfasst:
Prüfen auf das Vorhandensein einer Kurzschlussanomalie zwischen dem Innenleiter (3) und dem äußeren angeordneten Element (2) auf der Grundlage einer Abklingzeit zwischen der Eingabe eines Stromwertes mit einem voreingestellten vorbestimmten Wert oder mehr, und dem Abklingen des Stromwertes unter einen vorbestimmten Stromschwellenwert, wobei der Stromwert durch einen Strom geliefert wird, der durch den Innenleiter (3) beim Anlegen einer Hochspannung fließt, die höher ist als eine Spannung, die während des normalen Gebrauchs der Glühkerze (1) an den Innenleiter (3) angelegt wird, für eine ausreichend kurze Zeit, um einen Temperaturanstieg des Innenleiters (3) aufgrund des Anlegens der Hochspannung zu unterdrücken,
wobei die Prüfung durchgeführt wird, wenn sich die Spuleneinheit bei Umgebungstemperatur befindet,
wobei mit einem Prozessor (77) bestimmt wird, ob die Abklingzeit größer als eine Referenzzeit ist, und in dem Fall, dass die Abklingzeit nicht größer als der Referenzwert ist, bestimmt wird, dass eine Kurzschlussanomalie vorliegt.

2. Verfahren nach Anspruch 1, wobei das Anlegen einer Hochspannung das Anlegen einer in einem Kondensator (75) gespeicherten elektrischen Ladung an den Innenleiter (3) umfasst.

3. Verfahren nach Anspruch 1 oder 2, wobei
das Gehäuse (21) ein röhrenförmiges Metallrohr ist, und
zusätzlich die Prüfung auf das Vorhandensein einer Kurzschlussanomalie durchgeführt wird, wenn die Spuleneinheit (31) durch Erregung erhitzt wird.

4. Verfahren nach einem der Ansprüche 1 bis 3, das das Anlegen der Hochspannung an den Innenleiter (3) für eine Zeitgeberperiode von 50 ms oder weniger umfasst.

5. Verfahren nach einem der Ansprüche 1 bis 4, bei dem eine elektrische Energiemenge von 10 J oder weniger in den Innenleiter (3) eingespeist wird.

6. Verfahren zur Herstellung und/oder Prüfung eines ummantelten Heizers (5) mit einer Metallspuleneinheit (31), die so konfiguriert ist, dass sie durch Erregung Wärme erzeugt, und einem rohrförmigen Metallrohr (21), das so konfiguriert ist, dass es die Spuleneinheit (31) aufnimmt,
**dadurch gekennzeichnet, dass**
das Verfahren das Prüfen auf das Vorhandensein einer Kurzschlussanomalie zwischen der Spuleneinheit (31) und dem Rohr (21) auf der Grundlage einer Abklingzeit zwischen der Eingabe eines Stromwertes mit einem voreingestellten vorbestimmten Wert oder mehr, und dem Abklingen des Stromwertes unter einen vorbestimmten Stromschwellenwert umfasst,
wobei der Stromwert durch einen Strom geliefert wird, der durch die Spuleneinheit (31) beim Anlegen einer Hochspannung fließt, die höher ist als eine Spannung, die während des normalen Gebrauchs des ummantelten Heizers (5) an die Spuleneinheit (31) angelegt wird, für eine Zeitspanne, die kurz genug ist, um einen Temperaturanstieg der Spuleneinheit (31) aufgrund des Anlegens der Hochspannung zu unterdrücken, wobei die Prüfung durchgeführt wird, wenn sich die Spuleneinheit bei einer Umgebungstemperatur befindet,
wobei mit einem Prozessor (77) bestimmt wird, ob die Abklingzeit größer als eine Referenzzeit ist, und in dem Fall, dass die Abklingzeit nicht größer als der Referenzwert ist, bestimmt wird, dass eine Kurzschlussanomalie vorliegt.

7. Verfahren nach Anspruch 6, wobei das Anlegen einer Hochspannung das Anlegen einer in einem Kondensator (75) gespeicherten elektrischen Ladung an die Spuleneinheit (31) umfasst.

8. Verfahren nach Anspruch 6 oder 7, wobei die Untersuchung auf das Vorhandensein einer Kurzschlussanomalie zusätzlich durchgeführt wird, wenn die Spuleneinheit (31) durch Erregung erhitzt wird.

9. Verfahren nach einem der Ansprüche 6 bis 8, bei dem die Hochspannung an die Spuleneinheit (31) für eine Zeitdauer von 50 ms oder weniger angelegt wird.

10. Verfahren nach einem der Ansprüche 6 bis 9, bei dem eine elektrische Energiemenge von 10 J oder weniger in die Spuleneinheit (31) eingespeist wird.

## Revendications

1. Procédé de fabrication et/ou d'inspection de bougie de préchauffage (1) comprenant un conducteur intérieur (3) et un élément disposé à l'extérieur (2), dans lequel
le conducteur intérieur (3) comprend un dispositif de chauffage (31) électriquement conductrice configurée pour générer de la chaleur par excitation, et un élément d'excitation (32) connecté en série avec l'unité de chauffage (31) pour fournir un chemin d'excitation au dispositif de chauffage (31), et
l'élément disposé à l'extérieur (2) comprend un logement (21) configuré pour y loger le dispositif de chauffage (31), et un élément tubulaire métallique (22) disposé sur une périphérie extérieure de l'élément d'excitation (32) ; dans lequel le dispositif de chauffage (31) est une unité à bobine métallique le procédé comprend:
l'inspection de la présence d'une anomalie de court-circuit entre le conducteur intérieur (3) et l'élément extérieur (2), basée sur un temps de décroissance entre l'entrée d'une valeur de courant d'une valeur prédéterminée ou plus et la décroissance de la valeur de courant en dessous d'une valeur de seuil de courant prédéterminée, dans laquelle la valeur du courant est fournie par un courant qui circule dans le conducteur interne (3) lors de l'application d'une haute tension supérieure à une tension appliquée pendant l'utilisation normale de la bougie de préchauffage (1) au conducteur interne (3) pendant un temps suffisamment court pour supprimer une augmentation de température du conducteur interne (3) due à l'application de la haute tension,
dans lequel l'inspection est effectuée lorsque le bloc de bobines est à température ambiante,
dans lequel on détermine avec un processeur (77) si le temps de décroissance est supérieur à un temps de référence, et dans le cas où le temps de décroissance n'est pas supérieur à la valeur de référence, on détermine qu'il y a une abomination de court-circuit.

2. Procédé selon la revendication 1, dans lequel ladite application d'une haute tension comprend l'application d'une charge électrique stockée dans un condensateur (75) au conducteur interne (3).

3. Procédé selon les revendications 1 ou 2, dans lequel
le boîtier (21) est un tube métallique tubulaire, et
de plus, le contrôle de la présence d'un court-circuit est effectué lorsque la bobine (31) est chauffée par l'alimentation électrique.

4. Procédé selon l'une des revendications 1 à 3, qui consiste à appliquer la haute tension au conducteur interne (3) pendant une période de temporisation de 50 ms ou moins.

5. Procédé selon l'une des revendications 1 à 4, qui consiste à introduire une quantité d'énergie électrique de 10 J ou moins dans le conducteur intérieur (3).

6. Procédé de fabrication et/ou d'inspection d'un dispositif de chauffage sous gaine (5) comprenant une unité de bobine métallique (31) configurée pour générer de la chaleur par excitation, et un tube métallique tubulaire (21) configuré pour loger l'unité de bobine (31),
**caractérisé en ce que**
le procédé comprend l'inspection de la présence d'une anomalie de court-circuit entre l'unité de bobine (31) et le tube (21) sur la base d'un temps de décroissance entre l'entrée d'une valeur de courant d'une valeur prédéterminée ou plus et la décroissance de la valeur de courant en dessous d'une valeur de seuil de courant prédéterminée, dans lequel la valeur du courant est fournie par un courant qui circule à travers le corps de bobine (31) lors de l'application d'une haute tension supérieure à une tension appliquée pendant l'utilisation normale du réchauffeur gainé (5) au corps de bobine (31) pendant une durée suffisamment courte pour supprimer une augmentation de la température du corps de bobine (31) due à l'application de la haute tension, dans lequel l'inspection est effectuée lorsque le corps de bobine est à température ambiante,
dans lequel on détermine avec un processeur (77) si le temps de décroissance est supérieur à un temps de référence, et dans le cas où le temps de décroissance n'est pas supérieur à la valeur de référence, on détermine qu'il y a une abomination de court-circuit.

7. Procédé selon la revendication 6, dans lequel ladite application d'une haute tension comprend l'application d'une charge électrique stockée dans un condensateur (75) à l'unité de bobine (31).

8. Procédé selon les revendications 6 ou 7, dans lequel ledit contrôle de la présence d'une anomalie de court-circuit est en outre effectué lorsque l'unité de bobine (31) est chauffée par excitation.

9. Procédé selon l'une des revendications 6 à 8, qui consiste à appliquer la haute tension à l'unité de bobine (31) pendant une période de temps de 50 ms ou moins.

10. Procédé selon l'une des revendications 6 à 9, qui consiste à introduire une quantité d'énergie électrique de 10 J ou moins dans l'unité de bobine (31).
